# EUROPÄISCHE PATENTSCHRIFT

(11) **EP 2 707 729 B1**
(45) Veröffentlichungstag und Bekanntmachung des Hinweises auf die Patenterteilung: **17.02.2021**
(21) Anmeldenummer: 12708326.9
(22) Anmeldetag: 12.03.2012
(51) Int. Cl.: G01P 15/12, G01D 3/032

(54) **AUSWERTESCHALTUNG FÜR FELDEFFEKTTRANSISTOR MIT BEWEGLICHER GATESTRUKTUR**
ANALYSIS CIRCUIT FOR FIELD EFFECT TRANSISTORS HAVING A DISPLACEABLE GATE STRUCTURE
CIRCUIT D'ÉVALUATION POUR TRANSISTOR À EFFET DE CHAMP AVEC UNE STRUCTURE DE GRILLE MOBILE

(30) Priorität: 10.05.2011 DE 102011075541
(43) Veröffentlichungstag der Anmeldung: 19.03.2014
(73) Patentinhaber: Robert Bosch GmbH, 70442 Stuttgart (DE)
(72) Erfinder: BUHMANN, Alexander, 72760 Reutlingen (DE); HENRICI, Fabian, 70195 Stuttgart (DE)
(86) Internationale Anmeldenummer: PCT/EP2012/054188
(87) Internationale Veröffentlichungsnummer: WO 2012/152468

(56) Entgegenhaltungen:
- EP-A2- 0 570 148
- DE-A1- 19 509 338
- US-A- 5 103 279
- US-A- 5 279 162
- US-A- 5 397 911
- US-A1- 2010 007 326

## Beschreibung

Die Erfindung betrifft eine Auswerteschaltung für einen Feldeffekttransistor mit beweglicher Gatestruktur, insbesondere für als mikromechanische Sensoren eingesetzte Feldeffekttransistoren.

### Stand der Technik

Feldeffekttransistoren mit beweglicher Gatestruktur, sogenannte "Moving Gate"-FETs eignen sich zur Detektion von kleinen Bewegungen. Sie besitzen generell ein sehr gutes Signal-zu-Rausch-Verhältnis und können daher beispielsweise als Beschleunigungssensoren in miniaturisierten Sensorkernen im Bereich der Inertialsensorik eingesetzt werden.

Feldeffekttransistoren mit beweglicher Gatestruktur weisen ein Substrat auf, in dem ein n-dotierter oder p-dotierter Kanal zwischen einem Draingebiet und einem Sourcegebiet eingebracht ist. Über dem Kanalbereich ist eine Isolationsschicht aufgebracht, über der wiederum eine Gatestruktur angeordnet ist. Die Gatestruktur ist dabei beweglich ausgestaltet, das heißt, dass eine auf die Gatestruktur einwirkende externe Kraft die Gatestruktur in einer Richtung senkrecht zu der Substratoberfläche und/oder in einer Richtung in der Ebene der Substratoberfläche auslenken kann. Durch diese Auslenkung ändert sich bei einer anliegenden Gatespannung an der Gatestruktur die Ladungsträgerdichte in dem Kanalbereich, was wiederum zu einer Widerstandsänderung zwischen Drain- und Sourcegebiet führt. Diese Widerstandsänderung kann gemessen werden, indem entweder eine konstante Gatespannung an die Gatestruktur angelegt wird, die Drain-Sourcespannung konstant gehalten wird und der durch den Feldeffekttransistor fließende Strom bzw. die durch die Auslenkung verursachte Stromstärkenänderung gemessen wird, oder ein konstanter Strom in den Feldeffekttransistor eingeprägt wird und die Änderung der Drain-Sourcespannung infolge der Auslenkung gemessen wird.

Die Druckschrift US 2002/0005530 A1 offenbart einen Feldeffekttransistor mit flexibel gelagerter Gateelektrode über einem planaren Substrat, wobei eine Beschleunigung des Feldeffekttransistors eine Auslenkung der Gateelektrode gegenüber dem Substrat zur Folge hat, wodurch eine Änderung der Stromstärke in einem Kanalbereich des Feldeffekttransistors messbar wird.

Die Druckschrift EP 0 990 911 A1 offenbart einen mikromechanischen Sensor auf der Basis eines Feldeffekttransistors mit beweglichem Gate, dessen Auslenkungen eine Variation des von dem Gate überlappten Kanalbereichs des Feldeffekttransistors hervorrufen.

Die Druckschrift WO 2010/1244889 A2 offenbart eine Auswerteschaltung für einen Feldeffekttransistor mit beweglichem Gate, welcher mit einem Referenztransistor in Reihe geschaltet ist. An einem Zwischenknoten zwischen den beiden Feldeffekttransistoren kann ein nicht lineares Messsignal des beweglichen Gates abgegriffen werden.

Die Druckschrift US 5 279 162 A offenbart einen Halbleitersensor.

Das Dokument US 2010/007326 A1 beschreibt einen Materialdetektor.

Das Dokument DE 195 09 338 A1 beschreibt einen Beschleunigungssensor.

Das Dokument EP 0 570 148 A2 offenbart ein Gerät zum Erzeugen eines elektrischen Signals zu einem elektrostatischen Potential auf einer Oberfläche.

### Offenbarung der Erfindung

Die vorliegende Erfindung schafft daher eine Auswerteschaltung für einen Transistor mit beweglicher Gatestruktur, mit einer Messschaltung, welche an einen Versorgungsspannungsanschluss der Auswerteschaltung gekoppelt ist, welche an einen Drainanschluss des Transistors koppelbar ist, und welche dazu ausgelegt ist, ein Messsignal, welches von der Stromstärke eines durch den Transistor fließenden Stroms abhängig ist, an einem Messanschluss auszugeben.

Gemäß einer weiteren Ausführungsform schafft die Erfindung einen mikromechanischen Sensor, insbesondere einen Beschleunigungssensor, mit einem Feldeffekttransistor, welcher eine bewegliche Gatestruktur aufweist, mit einem Sourceanschluss, welcher mit einem Bezugspotential gekoppelt ist, einem Drainanschluss und einem Gateanschluss, an welchem eine konstante Gatespannung angelegt ist, und einer erfindungsgemäßen Auswerteschaltung, welche mit dem Drainanschluss des Feldeffekttransistors gekoppelt ist, und welche dazu ausgelegt ist, ein erstes Messsignal, welches von der Stromstärke eines durch den Feldeffekttransistor fließenden Stroms abhängig ist, an dem Messanschluss auszugeben.

### Vorteile der Erfindung

Eine grundlegende Idee der Erfindung ist es, eine Auswerteschaltung für einen Feldeffekttransistor mit beweglichem Gate anzugeben, bei der zum Einen der um Größenordnungen höhere Grundstrom nicht mehr mitverstärkt werden muss und bei der zum Anderen der differentielle Ausgangswiderstand des Feldeffekttransistors erhöht wird. Beide Effekte tragen zu einer erheblichen Erhöhung des Signal-zu-Rausch-Verhältnis des Messsignals der Auswerteschaltung bei, wodurch die Auswerteschaltung nur noch auf einen geringeren Dynamikbereich ausgelegt werden muss.

Auf der Isolationsschicht von Feldeffekttransistoren können sich Oberflächenladungen ansammeln, durch die die Ladungsträgerdichte in dem Kanalbereich zusätzlich beeinflusst wird. Verfälschungen der in Abhängigkeit von den Auslenkungen der Gatestruktur variablen Ladungsträgerdichte können vorteilhafterweise mit der Auswerteschaltung eliminiert werden, auch für Oberflächenladungen, die bereits während der Fertigung der einzelnen Feldeffekttransistoren mit beweglicher Gatestruktur oder auch während der Lebens- und Einsatzdauer des Feldeffekttransistors auftreten können. Zudem können Schwankungen der Oberflächenladungen in Abhängigkeit von der Umgebungstemperatur oder anderer Umgebungsparameter durch die erfindungsgemäße Auswerteschaltung ausgeglichen werden.

Mit einer derartigen Auswerteschaltung ist es möglich, eine Streuung des Arbeitspunktes des Feldeffekttransistors zu minimieren. Zwar können oberflächenladungsbedingte Schwankungen des Grundstroms im Mikroamperebereich liegen, während die zu messenden Stromstärkenänderungen sich im Pico- bis Nanoamperebereich bewegen - da aber das Auftreten von im Vergleich zum eigentlichen Messsignal sehr hoher Offsetströme in der Auswerteschaltung effektiv verhindert werden kann, kann die Auswerteschaltung vorteilhafterweise auf einen begrenzten Dynamikbereich ausgelegt werden. Dadurch wird das Verstärken des eigentlichen Messsignals auf einen gewünschten Signalpegel von etwa 60 bis 80 dB erheblich erleichtert, da keine Offsetströme, die sehr leicht zu einem Übersteuern der Auswerteschaltung führen könnten, gleichzeitig mitverstärkt werden müssen.

Die Auswerteschaltung weist eine Impedanzwandlerschaltung mit einem Referenzspannungsanschluss auf, welche an die Messschaltung gekoppelt ist, welche an den Drainanschluss des Feldeffekttransistors koppelbar ist, und welche dazu ausgelegt ist, den Drainanschluss des Feldeffekttransistors auf dem Potential einer an dem Referenzspannungsanschluss angelegten Referenzspannung zu halten. Dies kann vorzugsweise über einen Sourcefolgertransistor, welcher an die Messschaltung gekoppelt ist und an den Drainanschluss des Feldeffekttransistors koppelbar ist, und einen Operationsverstärker erfolgen. Dadurch entsteht der Vorteil, dass die Source-Drain-Spannung des Feldeffekttransistors konstant gehalten wird und sich dadurch der effektive differentielle Ausgangswiderstand des Feldeffekttransistors erhöht. Insbesondere im linearen Messbereich kann damit eine erhebliche Steigerung des Signalhubs erreicht werden. Außerdem kann vorteilhafterweise über eine Variation der Referenzspannung aus der Änderung des Ausgangsstroms auf die Empfindlichkeit des Feldeffekttransistors zurückgeschlossen werden.

In einer bevorzugten Ausführungsform weist die Auswerteschaltung eine Offsetkorrekturschaltung mit einem Offsetsignaleinspeiseanschluss auf, welche an den Versorgungsspannungsanschluss gekoppelt ist, welche an den Drainanschluss des Feldeffekttransistors koppelbar ist, und welche dazu ausgelegt ist, einen an dem Drainanschluss des Feldeffekttransistors auftretenden Grundstrom über ein an dem Offsetsignaleinspeiseanschluss eingespeistes Offsetkorrektursignal zu kompensieren. Dies wird in vorteilhafterweise durch eine Stromquellenschaltung mit sehr hohem Ausgangswiderstand, beispielsweise einer Stromspiegelschaltung oder einer Kaskodenschaltung erreicht, welche zwei Eingangsanschlüsse, die jeweils mit dem Versorgungsspannungsanschluss verbunden sind, einen ersten Ausgangsanschluss, der mit dem Drainanschluss des Feldeffekttransistors koppelbar ist, und einen zweiten Ausgangsanschluss, der mit dem Offsetsignaleinspeiseanschluss gekoppelt ist, aufweist. Dies bietet den Vorteil, das eigentliche Messsignal erheblich besser verstärken zu können, ohne den Grundstrom mitverstärken zu müssen. Dadurch wird der Dynamikbereich der Auswerteschaltung unabhängig von Grundstrom. Insbesondere die Variationen durch schwankende Oberflächenladungen im Kanalbereich des Feldeffekttransistors müssen durch die Auswerteschaltung nicht mehr mitverstärkt werden, wodurch kein Übersteuern der Auswerteschaltung mehr auftritt.

Weitere Merkmale und Vorteile von Ausführungsformen der Erfindung ergeben sich aus der nachfolgenden Beschreibung mit Bezug auf die beigefügten Zeichnungen.

### Kurze Beschreibung der Zeichnungen

Es zeigen:
- Fig. 1 bis 5: schematische Darstellungen von Auswerteschaltungen für einen Feldeffekttransistor mit beweglicher Gatestruktur gemäß Ausführungsformen der Erfindung;
- Fig. 6: eine schematische Darstellung einer pseudo-differentiellen Auswerteschaltung für zwei Feldeffekttransistoren mit beweglicher Gatestruktur gemäß einer weiteren Ausführungsform der Erfindung;
- Fig. 7: eine schematische Darstellung einer volldifferentiellen Auswerteschaltung für zwei Feldeffekttransistoren mit beweglicher Gatestruktur gemäß einer weiteren Ausführungsform der Erfindung;
- Fig. 8 bis 11: schematische Darstellungen von Auswerteschaltungen für einen Feldeffekttransistor mit beweglicher Gatestruktur gemäß weiteren Ausführungsformen der Erfindung;
- Fig. 12: eine schematische Darstellung einer pseudo-differentiellen Auswerteschaltung für zwei Feldeffekttransistoren mit beweglicher Gatestruktur gemäß einer weiteren Ausführungsform der Erfindung; und
- Fig. 13: eine schematische Darstellung einer volldifferentiellen Auswerteschaltung für zwei Feldeffekttransistoren mit beweglicher Gatestruktur gemäß einer weiteren Ausführungsform der Erfindung.

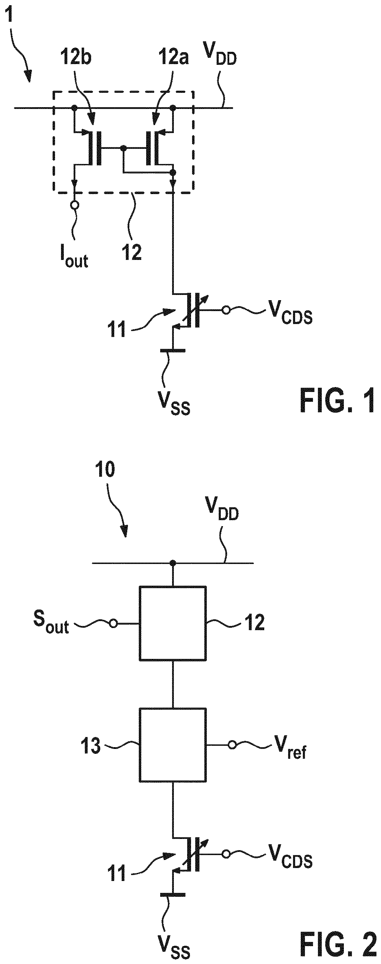

Fig. 1 zeigt eine schematische Darstellung einer Auswerteschaltung 1 für einen Feldeffekttransistor (FET) 11 mit beweglicher Gatestruktur. Der FET 11 kann beispielsweise ein n-Kanal-MOSFET sein. Der FET 11 weist einen Sourceanschluss auf, welcher mit einem Bezugspotential V_{SS}, beispielsweise einem Massepotential verbunden ist. Der FET 11 weist ferner einen Gateanschluss auf, an dem eine Gatespannung V_{CDS} angelegt werden kann. Die Gatespannung V_{CDS} kann dabei beispielsweise eine konstante Spannung sein. Der FET 11 weist überdies einen Drainanschluss auf, welcher mit einer Messschaltung 12 gekoppelt ist. Es ist für den Fachmann klar, dass für den FET 11 ebenso ein p-Kanal-MOSFET verwendet werden kann, wobei die Source- und Drainanschlüsse entsprechend verschaltet sind. Ferner kann für den FET 11 auch ein (nicht gezeigter) Bulkanschluss vorgesehen sein, um fertigungsbedingten Streuungen im Kanalbereich des FETs 11 entgegenzuwirken.

Die Messschaltung 12 ist dazu ausgelegt, eine Stromstärke eines Stroms, welcher durch den Kanalbereich des FETs 11 hindurchfließt, zu messen und an einem Signalausgang bereitzustellen. Beispielhaft umfasst die Messschaltung 12 eine Stromspiegelschaltung aus zwei Transistoren 12a und 12b, welche jeweils über ihre Eingangsanschlüsse mit einem Versorgungsspannungsanschluss V_{DD} der Auswerteschaltung 1 gekoppelt sind. Ein Ausgangsanschluss eines Transistors 12a ist mit dem Drainanschluss des FETs 11 gekoppelt. Ein Ausgangsanschluss eines Transistors 12b ist mit dem Signalausgang der Messschaltung 12 gekoppelt. Durch den Transistor 12a der Stromspiegelschaltung fließt die Stromstärke, die durch den Kanalbereich des FETs 11 fließt. Die Stromspiegelschaltung spiegelt den durch den Transistor 12a fließenden Strom auf den Transistor 12b, so dass an dem Signalausgang der Messschaltung 12 ein Stromstärkensignal lₒᵤₜ ausgegeben wird, welches proportional zu der Stromstärke des durch den FET 11 fließenden Stroms ist. Dabei können die Transistoren 12a und 12b entsprechend dimensioniert werden, dass das Stromstärkensignal lout ein Vielfaches der Stromstärke des durch den FET 11 fließenden Stroms beträgt, beispielsweise das Ein- bis Zehntausendfache. In einer bevorzugten Variante kann der Verstärkungsfaktor 10 bis 1000 betragen. Die Verstärkung der Stromspiegelschaltung stellt dabei eine Verstärkung des Stromstärkensignals lout auf einer ersten Stufe dar, und es ist selbstverständlich, dass das Stromstärkensignal lout in weiteren Stufen der Verarbeitung weiter verstärkt werden kann.

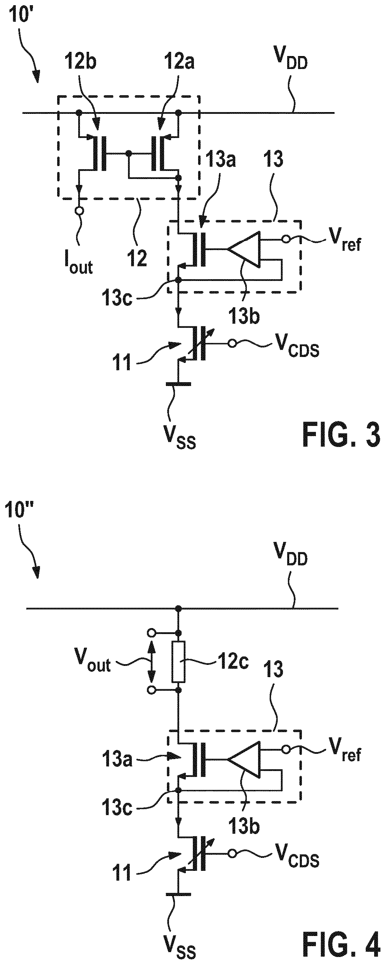

Fig. 2 zeigt eine schematische Darstellung einer Auswerteschaltung 10 für einen Feldeffekttransistor (FET) 11 mit beweglicher Gatestruktur. Die Auswerteschaltung 10 umfasst einen FET 11, eine Messschaltung 12 mit einem Messanschluss Sₒᵤₜ und eine Impedanzwandlerschaltung 13 mit einem Referenzspannungsanschluss V_{ref}, welche dazu ausgelegt ist, die differentielle Ausgangsimpedanz des FETs 11 zu erhöhen. In den Fig. 3 bis 5 sind beispielhafte Ausführungsformen der in Fig. 2 gezeigten Auswerteschaltung 10 gezeigt.

Fig. 3 zeigt eine schematische Darstellung einer Auswerteschaltung 10' für einen Feldeffekttransistor (FET) 11 mit beweglicher Gatestruktur. Die Auswerteschaltung 10' unterscheidet sich von der Auswerteschaltung 1 dadurch, dass ein Impedanzwandlerschaltung 13 zwischen den Drainanschluss 13c des FETs 11 und die Messschaltung 12 gekoppelt ist. Die Impedanzwandlerschaltung 13 kann beispielsweise einen Sourcefolgertransistor 13a umfassen, welcher zwischen den Drainanschluss 13c des FETs 11 und die Messschaltung 12 gekoppelt ist. Weiterhin kann die Impedanzwandlerschaltung 13 einen Operationsverstärker 13b mit einem Ausgangsanschluss, welcher mit einem Gateanschluss des Sourcefolgertransistors 13a gekoppelt ist, einem invertierenden Eingangsanschluss, welcher mit dem Drainanschluss 13c des Feldeffekttransistors 11 gekoppelt ist, und einem nicht-invertierenden Eingangsanschluss, welcher mit dem Referenzspannungsanschluss V_{ref} gekoppelt ist, umfassen. Der Operationsverstärker 13b hält mit Hilfe des Sourcefolgertransistors 13a den Drainanschluss 13c des FETs 11 auf einem konstanten Potential, welches durch eine vorzugsweise konstante Referenzspannung an dem Referenzspannungsanschluss V_{ref} bestimmt wird. Der Sourcefolgertransistors 13a ist in Fig. 3 als n-Kanal-MOSFET dargestellt. Es ist jedoch klar, dass ebenso ein p-Kanal-MOSFET als Sourcefolgertransistor 13a eingesetzt werden kann. Dieser wirkt dann wie ein variabler Widerstand.

Fig. 4 zeigt eine schematische Darstellung einer Auswerteschaltung 10" für einen Feldeffekttransistor (FET) 11 mit beweglicher Gatestruktur. Die Auswerteschaltung 10" unterscheidet sich von der Auswerteschaltung 10' dadurch, dass die Messschaltung 12 einen Shunt-Widerstand 12c umfasst, an dem ein Spannungssignal Vₒᵤₜ abgegriffen werden kann, welches von der Stromstärke des durch den Shunt-Widerstand 12c fließenden Stroms abhängig ist.

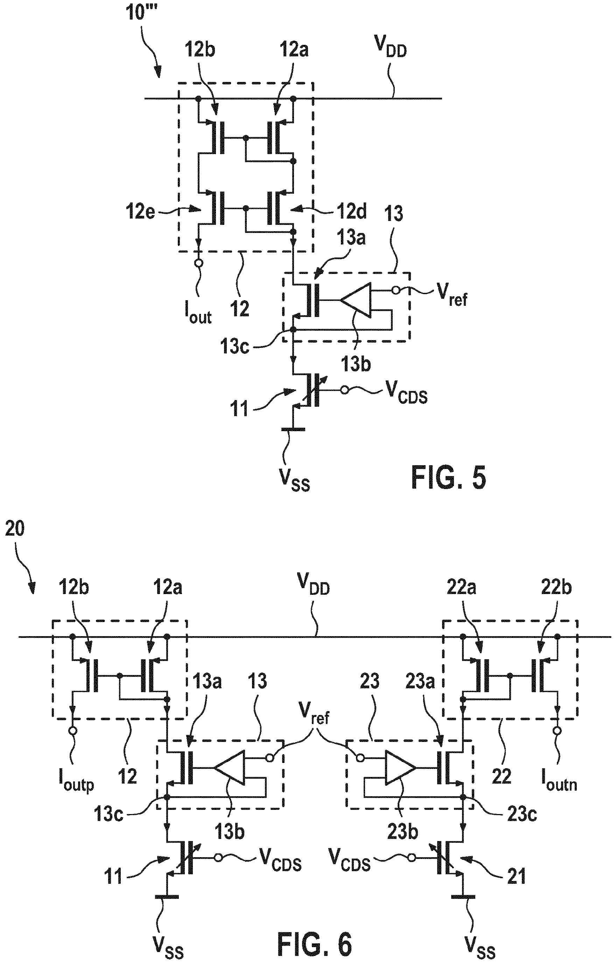

Fig. 5 zeigt eine schematische Darstellung einer Auswerteschaltung 10'" für einen Feldeffekttransistor (FET) 11 mit beweglicher Gatestruktur. Die Auswerteschaltung 10'" unterscheidet sich von der Auswerteschaltung 10" dadurch, dass die Messschaltung 12 eine Kaskodenschaltung aus vier Transistoren 12a, 12b, 12d und 12e umfasst. Die Kaskodenschaltung kann dabei eine serielle Verschaltung zweier Stromspiegelschaltungen wie in Fig. 1 gezeigt sein. Durch die Verwendung einer Kaskodenschaltung kann gegenüber einer einfachen Stromspiegelschaltung die Linearität des Messsignals und die Verstärkung der Auswerteschaltung verbessert werden. Alternativ kann statt einer Kaskodenschaltung auch eine aktive Stromspiegelschaltung für die Messschaltung 12 verwendet werden.

Fig. 6 zeigt eine schematische Darstellung einer Auswerteschaltung 20 für zwei Feldeffekttransistoren (FET) 11 und 21 mit jeweils beweglicher Gatestruktur. Die Auswerteschaltung 20 ist eine pseudo-differentielle Auswerteschaltung aus zwei Auswerteschaltungen 10' wie sie in Fig. 3 gezeigt und erläutert worden sind. Dabei entsprechen die mit den Bezugszeichen 23 und 22 bezeichneten Mess- bzw. Impedanzwandlerschaltungen des einen Auswertepfades den mit den Bezugszeichen 13 und 12 bezeichneten Mess- bzw. Impedanzwandlerschaltungen des anderen Auswertepfades. Die beweglichen Gatestrukturen der FETs 11 und 21 können dabei so angeordnet werden, dass sich die beweglichen Gatestrukturen unter dem Einfluss einer externen Kraft, beispielsweise einer externen Beschleunigung, gegenläufig bewegen, so dass Gleichtaktstörsignale, beispielsweise durch die Versorgungsspannung, unterdrückt werden können. An den zwei Ausgangsanschlüssen der Messschaltungen 12 und 22 können dabei Stromstärkensignale lₒᵤₜₚ bzw. lₒᵤₜₙ ausgelesen werden, deren Differenz dem Messsignal entsprechen kann. Über die pseudo-differentielle Auslegung der Auswerteschaltung 20 kann ein Digitalisierung des Messsignals vereinfacht werden und Änderungen des Grundstroms, beispielsweise durch Änderungen der Oberflächenladungen in den Kanalbereichen der FETs 11 und 21 durch Alterungs- und/oder Temperatureinflüsse ermittelt und ausgeglichen werden, da derartige Einflüsse sich nur in Gleichtaktsignalen niederschlagen und somit von dem differentiellen Messsignal unterschieden werden können.

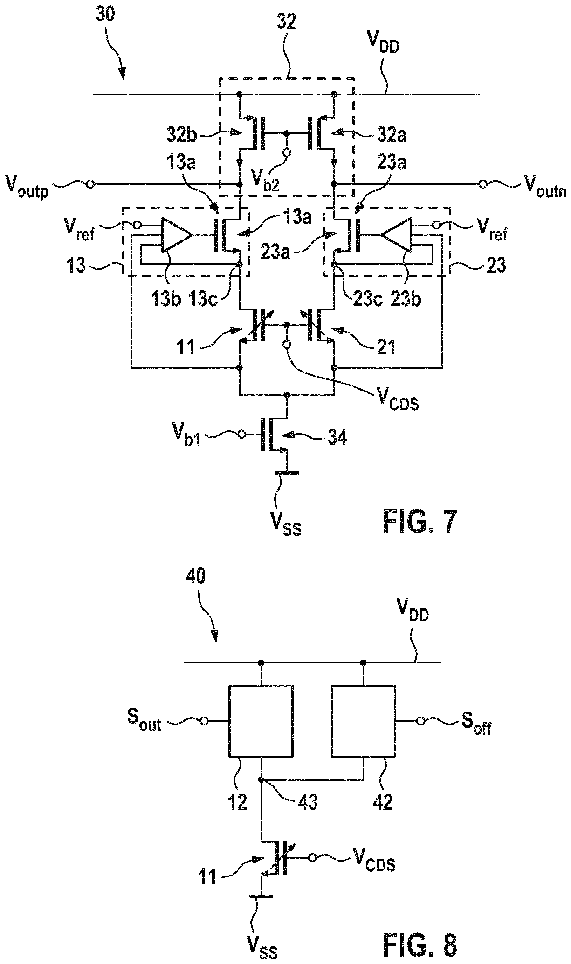

Fig. 7 zeigt eine schematische Darstellung einer volldifferentiellen Auswerteschaltung 30 für zwei Feldeffekttransistoren (FET) 11 und 21 mit beweglicher Gatestruktur. Ein Transistor 34 dient als Konstantstromquelle und ist mit einem Sourceanschluss mit einem Bezugspotential V_{SS} verbunden und wird über eine erste Vorspannung V_{b1} an seinem Gateanschluss versorgt. Der Transistor 34 kann auch als Kaskodenschaltung ausgeführt sein. An dem Drainanschluss des Vorspannungstransistors 34 sind die Sourceanschlüsse der FETs 11 und 21 gekoppelt, welche an ihren Gateanschlüssen mit der Gatespannung V_{CDS} versorgt werden. Die Drainanschlüsse 13c, 23c der FETs 11 und 21 sind mit den Impedanzwandlerschaltungen 13 bzw. 23 gekoppelt, die ähnlich den Impedanzwandlerschaltungen 13 und 23 in Fig. 6 aufgebaut sein können. Darüber hinaus können die Operationsverstärker 13b und 23b über weitere Eingangsanschlüsse verfügen, welche mit dem Drainanschluss des Vorspannungstransistors 34 gekoppelt sind. Die Impedanzwandlerschaltungen 13 und 23 sind jeweils mit Transistoren 32a bzw. 32b der Messschaltung 32 verbunden, die ihrerseits mit dem Versorgungsspannungsanschluss V_{DD} der Auswerteschaltung 30 gekoppelt sind. Die Transistoren 32a und 32b werden über einen Gateanschluss jeweils mit einer zweiten Vorspannung V_{b2} versorgt. An zwei Messanschlüssen der Messschaltung 32 können zwei Spannungssignale Vₒᵤₜₚ und Vₒᵤₜₙ abgegriffen werden, welche ein differentielles Messsignal bereitstellen, welches von den durch die Auslenkungen der beweglichen Gatestrukturen der FETs 11 bzw. 21 verursachten Stromstärkenänderungen des durch die Kanalbereiche der FETs 11 bzw. 21 fließenden Ströme abhängig ist.

Mithilfe der volldifferentiellen Auswerteschaltung 30 können Gleichtaktstörungen effektiv unterdrückt werden. Es versteht sich, dass die beispielhaften Ausgestaltungen der Messschaltungen 12 sowie der Impedanzwandlerschaltungen 13 in den Fig. 1 bis 5 ebenso in den differentiellen Auswerteschaltungen der Fig. 6 und 7 eingesetzt werden können.

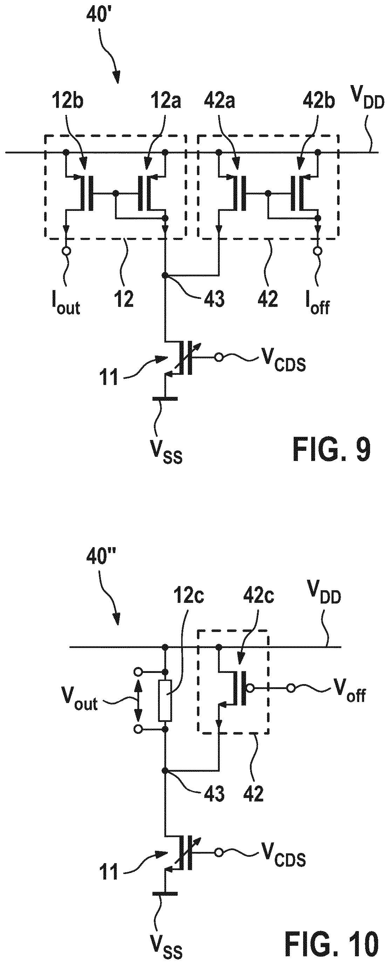

Fig. 8 zeigt eine schematische Darstellung einer Auswerteschaltung 40 für einen Feldeffekttransistor (FET) 11 mit beweglicher Gatestruktur. Die Auswerteschaltung 40 umfasst einen FET 11, eine Messschaltung 12 mit einem Messanschluss Sout und eine Offsetkorrekturschaltung 42 mit einem Offsetsignaleinspeiseanschluss Soff, welche dazu ausgelegt ist, einen Grundstrom, welcher durch den Kanalbereich des FETs 11 fließt, an dem Drainanschluss 43 des FETs 11 abzuführen. Der Strom, welcher durch den Drainanschluss des FETs 11 fließt, setzt sich aus einem Grundstrom und einem Messstrom zusammen. Der Grundstrom ist derjenige Strom, der unabhängig von einer Auslenkung der beweglichen Gatestruktur durch den Kanalbereich des FETs 11 fließt. Die Stromstärke des Grundstroms kann beispielsweise im Bereich von einigen Mikroampere liegen. Der Messstrom hingegen ist derjenige Anteil, der durch die Bewegung der beweglichen Gatestrukturen verursacht wird, und für die Bildung des Messsignals in der Messschaltung 12 von Interesse ist. Durch das Ableiten des Grundstroms bzw. das Einprägen eines den Grundstrom aufhebenden Gegenstroms durch die Offsetkorrekturschaltung 42 am Drainanschluss 43 des FETs 11 wird die Messschaltung 12 nur noch mit dem Messstrom versorgt, so dass die Verstärkung des Messstroms, welcher eine Stromstärke in einem Bereich von Pico- bis Nanoampere aufweisen kann, wesentlich höher gewählt werden kann, ohne dass die Auswerteschaltung 40 übersteuert. Weiterhin wird dadurch das Signal-zu-Rausch-Verhältnis der Messschaltung 12 erheblich verbessert. In den Fig. 9 bis 11 sind beispielhafte Ausführungsformen der in Fig. 8 gezeigten Auswerteschaltung 40 gezeigt.

Fig. 9 zeigt eine schematische Darstellung einer Auswerteschaltung 40' für einen Feldeffekttransistor (FET) 11 mit beweglicher Gatestruktur. Die Auswerteschaltung 40' unterscheidet sich von der Auswerteschaltung 1 dadurch, dass ein Offsetkorrekturschaltung 42 zwischen den Drainanschluss 43 des FETs 11 und die Messschaltung 12 gekoppelt ist. Die Offsetkorrekturschaltung 42 kann beispielsweise eine Stromspiegelschaltung aus zwei Transistoren 42a und 42b aufweisen, über welche ein Offsetkorrekturstrom l_{off} in den Drainanschluss 43 des FETs 11 eingeprägt werden kann. Der Offsetkorrekturstrom l_{off} kann vorzugsweise so gewählt werden, dass er den Grundstrom, der durch den Kanalbereich des FETs 11 fließt gerade aufhebt.

Fig. 10 zeigt eine schematische Darstellung einer Auswerteschaltung 40" für einen Feldeffekttransistor (FET) 11 mit beweglicher Gatestruktur. Die Auswerteschaltung 40" unterscheidet sich von der Auswerteschaltung 40' dadurch, dass die Messschaltung 12 einen Shunt-Widerstand 12c umfasst, an dem ein Spannungssignal Vout abgegriffen werden kann, welches von der Stromstärke des durch den Shunt-Widerstand 12c fließenden Stroms abhängig ist. Weiterhin umfasst die Offsetkorrekturschaltung 42 einen p-Kanal-MOSFET 42c, welcher an einem Gateanschluss mit einer variablen Offsetspannung V_{off} versorgt werden kann.

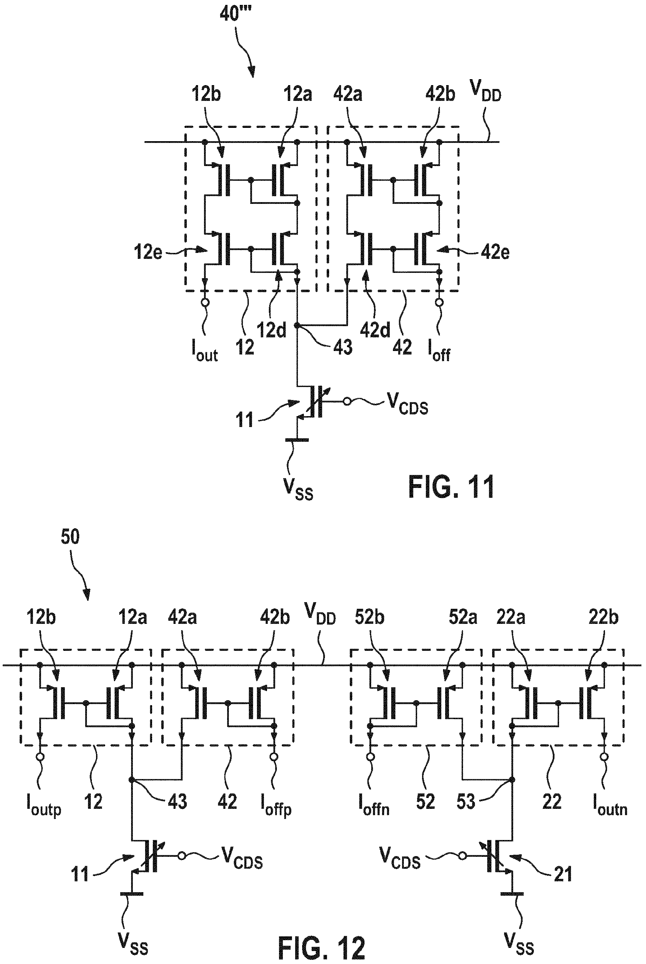

Fig. 11 zeigt eine schematische Darstellung einer Auswerteschaltung 40'" für einen Feldeffekttransistor (FET) 11 mit beweglicher Gatestruktur. Die Auswerteschaltung 40'" unterscheidet sich von der Auswerteschaltung 40' dadurch, dass die Messschaltung 12 und die Offsetkorrekturschaltung 42 jeweils eine Kaskodenschaltung aus vier Transistoren 12a, 12b, 12d und 12e bzw. 42a, 42b, 42d und 42e umfassen. Die Kaskodenschaltungen können dabei eine serielle Verschaltung zweier Stromspiegelschaltungen wie in Fig. 1 bzw. Fig. 9 gezeigt sein. Durch die Verwendung von Kaskodenschaltung kann gegenüber einfachen Stromspiegelschaltungen die Linearität des Messsignals und die Verstärkung der Auswerteschaltung verbessert werden. Alternativ können statt Kaskodenschaltungen auch aktive Stromspiegelschaltungen für die Messschaltung 12 bzw. die Offsetkorrekturschaltung 42 verwendet werden.

Fig. 12 zeigt eine schematische Darstellung einer Auswerteschaltung 50 für zwei Feldeffekttransistoren (FET) 11 und 21 mit jeweils beweglicher Gatestruktur. Die Auswerteschaltung 50 ist eine pseudo-differentielle Auswerteschaltung aus zwei Auswerteschaltungen 40' wie sie in Fig. 9 gezeigt und erläutert worden sind. Dabei entsprechen die mit den Bezugszeichen 22 und 52 bezeichneten Mess- bzw.

Offsetkorrekturschaltungen des einen Auswertepfades den mit den Bezugszeichen 12 und 42 bezeichneten Mess- bzw. Offsetkorrekturschaltungen des anderen Auswertepfades. Die Offsetkorrekturschaltungen 42 und 52 können dabei unabhängig voneinander mit zwei Offsetkorrekturstromsignalen 1_{offp} und l_{offn} beaufschlagt werden, um prozessbedingte Streuungen in den FETs 11 und 21 ausgleichen zu können. Die beweglichen Gatestrukturen der FETs 11 und 21 können dabei so angeordnet werden, dass sich die beweglichen Gatestrukturen unter dem Einfluss einer externen Kraft, beispielsweise einer externen Beschleunigung, gegenläufig bewegen, so dass Gleichtaktstörsignale, beispielsweise durch die Versorgungsspannung, unterdrückt werden können. An den zwei Ausgangsanschlüssen der Messschaltungen 12 und 22 können dabei Stromstärkensignale lₒᵤₜₚ bzw. lₒᵤₜₙ ausgelesen werden, deren Differenz dem Messsignal entsprechen kann. Über die pseudo-differentielle Auslegung der Auswerteschaltung 50 kann ein Digitalisierung des Messsignals vereinfacht werden und Änderungen des Grundstroms, beispielsweise durch Änderungen der Oberflächenladungen in den Kanalbereichen der FETs 11 und 21 durch Alterungs- und/oder Temperatureinflüsse ermittelt und ausgeglichen werden, da derartige Einflüsse sich nur in Gleichtaktsignalen niederschlagen und somit von dem differentiellen Messsignal unterschieden werden können.

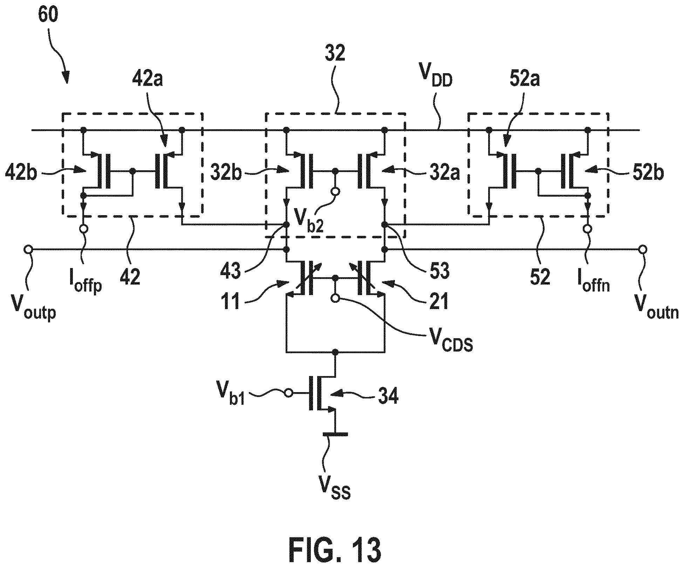

Fig. 13 zeigt eine schematische Darstellung einer volldifferentiellen Auswerteschaltung 60 für zwei Feldeffekttransistoren (FET) 11 und 21 mit beweglicher Gatestruktur. Die Messschaltung 32 sowie der Vorspannungstransistor 34 entsprechen dabei den in Fig. 7 gezeigten Komponenten der Auswerteschaltung 30, während die Offsetkorrekturschaltungen 42 und 52 den entsprechenden Offsetkorrekturschaltungen in Fig. 12 entsprechen.

Mithilfe der volldifferentiellen Auswerteschaltung 60 können Gleichtaktstörungen effektiv unterdrückt werden. Es versteht sich, dass die beispielhaften Ausgestaltungen der Messschaltungen 12 sowie der Offsetkorrekturschaltungen 42 in den Fig. 1 bis 11 ebenso in den differentiellen Auswerteschaltungen der Fig. 12 und 13 eingesetzt werden können.

Die in den Fig. 1 bis 13 gezeigten Auswerteschaltungen können jeweils mit den entsprechenden FETs in mikromechanischen Sensoren, beispielsweise in Beschleunigungssensoren, Drehratensensoren, Drucksensoren oder ähnlichen Sensoren eingesetzt werden.

## Patentansprüche

1. Auswerteschaltung (1; 10; 10'; 10"; 10"'; 20; 30; 40) für einen Feldeffekttransistor (11) mit beweglicher Gatestruktur, mit:
einer Messschaltung (12), welche an einen Versorgungsspannungsanschluss (V_{DD}) der Auswerteschaltung (1; 10; 10'; 10"; 10"'; 20; 30; 40) gekoppelt ist welche an einen Drainanschluss des Feldeffekttransistors (11) koppelbar ist, und welche dazu ausgelegt ist, ein Messsignal (Iₒᵤₜ; Vₒᵤₜ), welches von der Stromstärke eines durch den Feldeffekttransistor (11) fließenden Stroms abhängig ist, an einem Messanschluss (Sₒᵤₜ) auszugeben, **gekennzeichnet durch** eine Impedanzwandlerschaltung (13) mit einem Referenzspannungsanschluss (V_{ref}), welche an die Messschaltung (12) gekoppelt ist, welche an den Drainanschluss (13c) des Feldeffekttransistors (11) koppelbar ist, und welche dazu ausgelegt ist, den Drainanschluss (13c) des Feldeffekttransistors (11) auf dem Potential einer an dem Referenzspannungsanschluss (V_{ref}) angelegten Referenzspannung zu halten, wobei die Impedanzwandlerschaltung (13) aufweist:
einen Sourcefolgertransistor (13a), welcher an die Messschaltung (12) gekoppelt ist und welcher an den Drainanschluss (13c) des Feldeffekttransistors (11) koppelbar ist; und
einen Operationsverstärker (13b) mit einem Ausgangsanschluss, welcher mit einem Gateanschluss des Sourcefolgertransistors (13a) gekoppelt ist, einem invertierenden Eingangsanschluss, welcher mit dem Drainanschluss (13c) des Feldeffekttransistors (11) koppelbar ist, und einem nicht-invertierenden Eingangsanschluss, welcher mit dem Referenzspannungsanschluss (V_{ref}) gekoppelt ist.

2. Auswerteschaltung (1; 10; 10'; 10"; 10'"; 20; 30; 40) nach Anspruch 1, wobei die Messschaltung (12) eine Stromspiegelschaltung umfasst, welche zwei Eingangsanschlüsse, die jeweils mit dem Versorgungsspannungsanschluss (V_{DD}) verbunden sind, einen ersten Ausgangsanschluss, der mit dem Drainanschluss des Feldeffekttransistors (11) koppelbar ist, und einen zweiten Ausgangsanschluss, der mit dem Messanschluss (Sₒᵤₜ) gekoppelt ist, aufweist.

3. Auswerteschaltung (1; 10; 10'; 10"; 10'"; 20; 30; 40) nach Anspruch 1, wobei die Messschaltung (12) einen Shunt-Widerstand (12c) aufweist, und wobei das Messsignal eine über den Shunt-Widerstand (12c) abfallende Spannung (Vₒᵤₜ) umfasst.

4. Auswerteschaltung (1; 10; 10'; 10"; 10"'; 20; 30; 40) nach Anspruch 1, wobei die Messschaltung (12) eine Kaskodenschaltung umfasst, welche zwei Eingangsanschlüsse, die jeweils mit dem Versorgungsspannungsanschluss (V_{DD}) verbunden sind, einen ersten Ausgangsanschluss, der mit dem Drainanschluss des Feldeffekttransistors (11) verbindbar ist, und einen zweiten Ausgangsanschluss, der mit dem Messanschluss (Sₒᵤₜ) gekoppelt ist, aufweist.

5. Auswerteschaltung (40) nach einem der Ansprüche 1 bis 4, weiterhin mit:
einer Offsetkorrekturschaltung (42) mit einem Offsetsignaleinspeiseanschluss (S_{off}), welche an den Versorgungsspannungsanschluss (V_{DD}) gekoppelt ist, welche an den Drainanschluss (43) des Feldeffekttransistors (11) koppelbar ist, und welche dazu ausgelegt ist, einen an dem Drainanschluss (43) des Feldeffekttransistors (11) auftretenden Grundstrom über ein an dem Offsetsignaleinspeiseanschluss (S_{off}) eingespeistes Offsetkorrektursignal zu kompensieren.

6. Auswerteschaltung (40) nach Anspruch 5, wobei die Offsetkorrekturschaltung (42) eine Stromspiegelschaltung oder eine Kaskodenschaltung umfasst, welche zwei Eingangsanschlüsse, die jeweils mit dem Versorgungsspannungsanschluss (V_{DD}) verbunden sind, einen ersten Ausgangsanschluss, der mit dem Drainanschluss (43) des Feldeffekttransistors (11) koppelbar ist, und einen zweiten Ausgangsanschluss, der mit dem Offsetsignaleinspeiseanschluss (S_{off}) gekoppelt ist, aufweist.

7. Mikromechanischer Sensor, mit:
einem ersten Feldeffekttransistor (11), welcher eine bewegliche Gatestruktur aufweist, mit einem Sourceanschluss, welcher mit einem Bezugspotential (V_{SS}) gekoppelt ist, einem Drainanschluss (13c; 43) und einem Gateanschluss, an welchem eine konstante Gatespannung (V_{CDS}) angelegt ist; und
einer ersten Auswerteschaltung nach einem der Ansprüche 1 bis 6, welche mit dem Drainanschluss (13c; 43) des ersten Feldeffekttransistors (11) gekoppelt ist, und welche dazu ausgelegt ist, ein erstes Messsignal, welches von der Stromstärke eines durch den ersten Feldeffekttransistor (11) fließenden Stroms abhängig ist, an dem Messanschluss (Sₒᵤₜ) auszugeben.

8. Mikromechanischer Sensor nach Anspruch 7, weiterhin mit:
einem zweiten Feldeffekttransistor (21), welcher eine bewegliche Gatestruktur aufweist, mit einem Sourceanschluss, welcher mit einem Bezugspotential gekoppelt ist, einem Drainanschluss (23c; 53) und einem Gateanschluss, an welchem eine konstante Gatespannung angelegt ist; und
einer zweiten Auswerteschaltung nach einem der Ansprüche 1 bis 6, welche mit dem Drainanschluss (23c; 53) des zweiten Feldeffekttransistors (21) gekoppelt ist, und welche dazu ausgelegt ist, ein zweites Messsignal, welches von der Stromstärke eines durch den zweiten Feldeffekttransistor (21) fließenden Stroms abhängig ist, an dem Messanschluss (Sₒᵤₜ) auszugeben,
wobei die bewegliche Gatestruktur des ersten Feldeffekttransistors (11) im Bezug auf die bewegliche Gatestruktur des zweiten Feldeffekttransistors (21) unter Einfluss einer auf den mikromechanischen Sensor einwirkenden externen Kraft gegenläufig beweglich ist.

## Claims

1. Analysis circuit (1; 10; 10'; 10''; 10'''; 20; 30; 40) for a field effect transistor (11) having a movable gate structure, comprising:
a measuring circuit (12), which is coupled on a supply voltage terminal (V_{DD}) of the analysis circuit (1; 10; 10'; 10''; 10'''; 20; 30; 40), which can be coupled on a drain terminal of the field effect transistor (11), and which is designed to output a measurement signal (Iₒᵤₜ; Vₒᵤₜ) at a measurement terminal (Sₒᵤₜ), said measurement signal being dependent on the current intensity of a current flowing through the field effect transistor (11), **characterized by**
an impedance converter circuit (13) having a reference voltage terminal (V_{ref}), said impedance converter circuit being coupled on the measuring circuit (12), which can be coupled on the drain terminal (13c) of the field effect transistor (11), and being designed to hold the drain terminal (13c) of the field effect transistor (11) at the potential of a reference voltage applied to the reference voltage terminal (V_{ref}), wherein the impedance converter circuit (13) has:
a source follower transistor (13a), which is coupled on the measuring circuit (12) and which can be coupled on the drain terminal (13c) of the field effect transistor (11); and
an operational amplifier (13b) having an output terminal, which is coupled to a gate terminal of the source follower transistor (13a), an inverting input terminal, which can be coupled to the drain terminal (13c) of the field effect transistor (11), and a noninverting input terminal, which is coupled to the reference voltage terminal (V_{ref}).

2. Analysis circuit (1; 10; 10'; 10''; 10'''; 20; 30; 40) according to Claim 1, wherein the measuring circuit (12) comprises a current mirror circuit having two input terminals, which are in each case connected to the supply voltage terminal (V_{DD}), a first output terminal, which can be coupled to the drain terminal of the field effect transistor (11), and a second output terminal, which is coupled to the measurement terminal (Sₒᵤₜ).

3. Analysis circuit (1; 10; 10'; 10''; 10'''; 20; 30; 40) according to Claim 1, wherein the measuring circuit (12) has a shunt resistor (12c), and wherein the measurement signal comprises a voltage (Vₒᵤₜ) dropping across the shunt resistor (12c).

4. Analysis circuit (1; 10; 10'; 10''; 10'''; 20; 30; 40) according to Claim 1, wherein the measuring circuit (12) comprises a cascode circuit having two input terminals, which are in each case connected to the supply voltage terminal (V_{DD}), a first output terminal, which can be connected to the drain terminal of the field effect transistor (11), and a second output terminal, which is coupled to the measurement terminal (Sₒᵤₜ).

5. Analysis circuit (40) according to any of Claims 1 to 4, furthermore comprising:
an offset correction circuit (42) having an offset signal feed terminal (S_{off}), said offset correction circuit being coupled on the supply voltage terminal (V_{DDE}), which can be coupled on the drain terminal (43) of the field effect transistor (11), and being designed to compensate for a basic current occurring at the drain terminal (43) of the field effect transistor (11) by means of an offset correction signal fed in at the offset signal feed terminal (S_{off}).

6. Analysis circuit (40) according to Claim 5, wherein the offset correction circuit (42) comprises a current mirror circuit or a cascode circuit having two input terminals, which are in each case connected to the supply voltage terminal (V_{DD}), a first output terminal, which can be coupled to the drain terminal (43) of the field effect transistor (11), and a second output terminal, which is coupled to the offset signal feed terminal (S_{off}).

7. Micromechanical sensor, comprising:
a first field effect transistor (11) having a movable gate structure, comprising a source terminal, which is coupled to a reference potential (V_{SS}), a drain terminal (13c; 43) and a gate terminal, to which a constant gate voltage (V_{CDS}) is applied; and
a first analysis circuit according to any of Claims 1 to 6, which is coupled to the drain terminal (13c; 43) of the first field effect transistor (11) and which is designed to output a first measurement signal at the measurement terminal (Sₒᵤₜ), said first measurement signal being dependent on the current intensity of a current flowing through the first field effect transistor (11).

8. Micromechanical sensor according to Claim 7, furthermore comprising:
a second field effect transistor (21) having a movable gate structure, comprising a source terminal, which is coupled to a reference potential, a drain terminal (23c; 53) and a gate terminal, to which a constant gate voltage is applied; and
a second analysis circuit according to any of Claims 1 to 6, which is coupled to the drain terminal (23c; 53) of the second field effect transistor (21) and which is designed to output a second measurement signal at the measurement terminal (Sₒᵤₜ), said second measurement signal being dependent on the current intensity of a current flowing through the second field effect transistor (21),
wherein the movable gate structure of the first field effect transistor (11) is movable in an opposite direction with respect to the movable gate structure of the second field effect transistor (21) under the influence of an external force acting on the micromechanical sensor.

## Revendications

1. Circuit d'évaluation (1 ; 10 ; 10' ; 10'' ; 10''' ; 20 ; 30 ; 40) destiné à un transistor à effet de champ (11) à structure de grille mobile, ledit circuit comprenant :
un circuit de mesure (12) qui est couplé à une borne de tension d'alimentation (V_{DD}) du circuit d'évaluation (1 ; 10 ; 10' ; 10" ; 10''' ; 20 ; 30 ; 40) qui peut être couplé à une borne de drain du transistor à effet de champ (11) et qui est conçu pour délivrer un signal de mesure (Iₒᵤₜ ; Vₒᵤₜ), qui dépend de l'intensité d'un courant circulant à travers le transistor à effet de champ (11), à une borne de mesure (Sₐᵤₜ), **caractérisé par**
un circuit convertisseur d'impédance (13) comprenant une borne de tension de référence (V_{ref}) qui est couplé au circuit de mesure (12) qui peut être couplé à la borne de drain (13c) du transistor à effet de champ (11) et qui est conçu pour maintenir la borne de drain (13c) du transistor à effet de champ (11) au potentiel d'une tension de référence appliquée à la borne de tension de référence (V_{ref}), le circuit convertisseur d'impédance (13) comprenant :
un transistor à source suiveuse (13a) qui est couplé au circuit de mesure (12) et qui peut être couplé à la borne de drain (13c) du transistor à effet de champ (11) ; et
un amplificateur opérationnel (13b) comportant une borne de sortie qui est couplée à une borne de grille du transistor à source suiveuse (13a), une borne d'entrée inverseuse qui peut être couplée à la borne de drain (13c) du transistor à effet de champ (11), et une borne d'entrée non inverseuse qui est couplée à la borne de tension de référence (V_{ref}).

2. Circuit d'évaluation (1 ; 10 ; 10' ; 10'' ; 10''' ; 20 ; 30 ; 40) selon la revendication 1, le circuit de mesure (12) comprenant un circuit miroir de courant qui comporte deux bornes d'entrée, qui sont chacune reliées à la borne de tension d'alimentation (V_{DD}), une première borne de sortie qui peut être couplée à la borne de drain du transistor à effet de champ (11), et une deuxième borne de sortie qui est couplée à la borne de mesure (Sₒᵤₜ).

3. Circuit d'évaluation (1 ; 10 ; 10' ; 10'' ; 10''' ; 20 ; 30 ; 40) selon la revendication 1, le circuit de mesure (12) comportant une résistance de shunt (12c), et le signal de mesure comprenant une tension (Vₒᵤₜ) qui décroît aux bornes de la résistance de shunt (12c).

4. Circuit d'évaluation (1 ; 10 ; 10' ; 10'' ; 10''' ; 20 ; 30 ; 40) selon la revendication 1, le circuit de mesure (12) comprenant un circuit cascode qui a deux connexions d'entrée, qui sont chacune connectées à la borne de tension d'alimentation (V_{DD}), une première borne de sortie qui peut être connectée à la borne de drain du transistor à effet de champ (11), et une seconde borne de sortie qui est couplée à la borne de mesure (Sₒᵤₜ).

5. Circuit d'évaluation (40) selon l'une des revendications 1 à 4, comprenant en outre :
un circuit de correction de décalage (42) comprenant une borne d'alimentation de signal de décalage (S_{off}) qui est couplée à la borne de tension d'alimentation (V_{DD}), qui peut être couplée à la borne de drain (43) du transistor à effet de champ (11), et qui est conçue pour compenser un courant de base, apparaissant à la borne de drain (43) du transistor à effet de champ (11), par le biais d'un signal de correction de décalage injecté au niveau de la borne d'alimentation de signal de décalage (S_{off}).

6. Circuit d'évaluation (40) selon la revendication 5, le circuit de correction de décalage (42) comprenant un circuit miroir de courant ou un circuit cascode qui comporte deux bornes d'entrée, qui sont chacune reliées à la borne de tension d'alimentation (V_{DD}), une première borne de sortie qui peut être couplée à la borne de drain (43) du transistor à effet de champ (11) et une deuxième borne de sortie qui est couplée à la borne d'alimentation de signal de décalage (S_{off}).

7. Capteur micromécanique, comprenant :
un premier transistor à effet de champ (11), à structure de grille mobile, comprenant une borne de source qui est couplée à un potentiel de référence (V_{SS}), une borne de drain (13c ; 43) et une borne de grille à laquelle une tension de grille constante (V_{CDS}) est appliquée ; et
un premier circuit d'évaluation selon l'une des revendications 1 à 6 qui est couplé à la borne de drain (13c ; 43) du premier transistor à effet de champ (11) et qui est conçu pour délivrer un premier signal de mesure, qui dépend de l'intensité d'un courant circulant à travers le premier transistor à effet de champ (11), à la borne de mesure (Sₒᵤₜ).

8. Capteur micromécanique selon la revendication 7, comprenant en outre :
un deuxième transistor à effet de champ (21) ayant une structure de grille mobile, comprenant une borne de source qui est couplée à un potentiel de référence, une borne de drain (23c ; 53) et une borne de grille à laquelle une tension de grille constante est appliquée ; et
un deuxième circuit d'évaluation selon l'une des revendications 1 à 6 qui est couplé à la borne de drain (23c ; 53) du deuxième transistor à effet de champ (21) et qui est conçu pour délivrer un deuxième signal de mesure, qui dépend de l'intensité d'un courant circulant à travers le deuxième transistor à effet de champ (21), à la borne de mesure (Sₒᵤₜ),
la structure de grille mobile du premier transistor à effet de champ (11) étant mobile dans des directions opposées par rapport à la structure de grille mobile du deuxième transistor à effet de champ (21) sous l'influence d'une force extérieure agissant sur le capteur micromécanique.
